# EUROPEAN PATENT SPECIFICATION

(11) **EP 4 523 282 B1**
(45) Date of publication and mention of the grant of the patent: **02.09.2026**
(21) Application number: 23726382.7
(22) Date of filing: 12.05.2023
(51) Int. Cl.: G06Q 10/30

(54) **DETERMINATION OF CHEMICAL FUNCTIONALITY AND/OR CHEMICAL COMPOSITION OF A BATTERY**
BESTIMMUNG DER CHEMISCHEN FUNKTIONALITÄT UND/ODER CHEMISCHEN ZUSAMMENSETZUNG EINER BATTERIE
DÉTERMINATION DE LA FONCTIONNALITÉ CHIMIQUE ET/OU DE LA COMPOSITION CHIMIQUE D'UNE BATTERIE

(30) Priority: 13.05.2022 EP 22173354; 13.05.2022 EP 22173355; 13.05.2022 EP 22173356; 20.05.2022 EP 22174664; 20.05.2022 EP 22174667
(43) Date of publication of application: 19.03.2025
(73) Proprietor: BASF SE, 67056 Ludwigshafen am Rhein (DE)
(72) Inventor: BINDER, Martin, 67061 Ludwigshafen am Rhein (DE); SCHWABE, Henning, 67056 Ludwigshafen am Rhein (DE); HAARDT, Dennis, 67056 Ludwigshafen am Rhein (DE); WOLF, Uwe, 67056 Ludwigshafen am Rhein (DE); VON MUEHLENEN, Adrian, 4800 Zofingen (CH); FAELSCH, Henrik, 67056 Ludwigshafen am Rhein (DE); PINGER, Yannick Karsten, 67056 Ludwigshafen am Rhein (DE); ECKARDT, Gabriele, 67061 Ludwigshafen am Rhein (DE); JELICH, Holger Kai Peter, 67061 Ludwigshafen am Rhein (DE)
(74) Representative: BASF IP Association
(86) International application number: PCT/EP2023/062796
(87) International publication number: WO 2023/218049

(56) References cited:
- EP-A1- 3 597 315
- WO-A1-2020/176627
- US-A1- 2013 151 181

## Description

### TECHNICAL FIELD

The present disclosure relates to a computer-implemented method for determining a chemical functionality and/or chemical composition of a battery, a system for determining a chemical functionality and/or chemical composition of a battery, a use of battery data and/or chemical functionality data of a battery and/or chemical composition data of a battery in such a method, a use of functionality and/or composition data determined by a such a method according for classification and/or sorting of batteries and a computer program element with instructions, which, when executed on computing devices of a computing environment, is configured to carry out the steps of such a method in such a system.

### TECHNICAL BACKGROUND

The general background of this disclosure concerns the processing of recycling batteries. The recycling of batteries is a subject of growing interest in a world with an increasing amount of portable electronic devices and automation. It is to be expected that a growing number of spent lithium ion batteries will emerge with the advent of e-mobility. Since batteries contain important transition metals such as, cobalt, nickel, lithium, spent lithium ion batteries may form a valuable source of raw materials for a new generation of lithium ion batteries, such that an processing of recycled battery materials is also a subject of growing interest in a world with an increasing amount of portable electronic devices and automation. For that reason, increased research work has been performed with the goal of recycling transition metals and lithium from used lithium ion batteries, or from batteries or parts thereof that do not meet the specifications and requirements; such off-spec materials and production waste may as well be a source of raw materials, and of processing the recycled battery materials.

In the context of recycling batteries, the question arises as to how and when a battery is to be recycled. In particular, whether a battery may still be suitable for a different/further use or whether a battery can no longer be used for a further use and should be "invasive" recycled. Therefore, there is a need to simplify or improve the decision-making process on whether, when and how to recycle batteries.

Document EP 3597315 A1 discloses a system for determining chemical properties of batteries and using them for sorting and/or processing of the batteries.

### SUMMARY OF THE INVENTION

In one aspect of the present disclosure, a computer-implemented method for determining a chemical functionality and/or chemical composition of a battery as defined in claim 1 is provided.

In a further aspect of the present disclosure, a system for determining a chemical functionality and/or chemical composition of a battery as defined in claim 6 is provided. and/or chemical composition of the battery based on the matching data.

A further aspect of the present disclosure relates to a use of battery data and/or chemical functionality data of a battery and/or chemical composition data of a battery in the method for determining a chemical functionality and/or chemical composition of a battery.

A still further aspect of the present disclosure relates to a use of functionality and/or composition data determined by in the method for determining a chemical functionality and/or chemical composition of a battery for classification and/or sorting of batteries.

In a further aspect of the present disclosure, a computer program element is provided with instructions, which, when executed on computing devices of a computing environment, is configured to carry out the steps of in the method for determining a chemical functionality and/or chemical composition of a battery in the system for determining a chemical functionality and/or chemical composition of a battery.

A further aspect of the present disclosure relates to a use of classification data/information for deciding between recycling or second/further use of a battery. The classification data/information may be provided as explained in the present disclosure.

Any disclosure and embodiments described herein relate to the methods, the systems, and the computer program elements lined out above and vice versa. Advantageously, the benefits provided by any of the embodiments and examples equally apply to all other embodiments and examples and vice versa.

As used herein "determining" also includes "initiating or causing to determine", "querying" also includes "initiating or causing to query, correlating and/or matching" and "providing" also includes "initiating or causing to determine, generate, select, send or receive". "Initiating or causing to perform an action" includes any processing signal that triggers a computing device to perform the respective action.

The method for determining a chemical functionality and/or chemical composition of a battery, the system for determining a chemical functionality and/or chemical composition of a battery, the use of battery data and/or chemical functionality data of a battery and/or chemical composition data of a battery and the respective computer program element allow an accurate assessment of the condition of a specific battery, whether it is still suitable for its intended use, whether the battery is still suitable for another use, or whether the battery should be recycled invasively. In other words, an extremely precise determination of the functional state as well as the chemical composition of a battery is provided by the present disclosure. This in turn enables an improved, particularly sustainable decision as to whether such battery or battery cell should either be put to further use ("2^{nd} life") use or "invasive" recycling. Thus, the sustainability and the environmental sustainability of the use of batteries can be improved. Therefore, the mining of chemical elements can be reduced and the ecological destruction and pollution normally occurring during the mining of chemical elements can be significantly reduced.

It is an object of the present invention to simplify or improve the decision-making process on whether, when and how to recycle batteries. In particular, it is an object of the present invention to support the decision whether a battery may still be suitable for a different/further use, and if yes, for which further use, or whether a battery can no longer be used for a further use and should be "invasive" recycled. These and other objects, which become apparent upon the following description, are solved by the subject matters of the independent claims. The dependent claims refer to preferred embodiments of the invention.

The term battery data may relate to at least one chemical and/or physical property. The property may be related to at least one chemical ingredient of the specific battery. The battery data may be provided by measurement of the chemical and/or physical property. The battery data may be provided by a property measurement device. The battery data may for example relate to voltage, current, charge characteristics of the battery. The battery data may for example include discharging and/or charging curves. Additionally or alternatively, battery data may be provided by providing an identifier, such as a decentral identifier, of the battery, e.g. by reading the identifier element of the battery. The battery data is to be understood broadly in the present case and refers to any data/information with respect to at least one chemical and/or physical property of a chemical ingredient of a specific battery, the further use of which is to be determined and which may be provided by a property measuring device. The property measuring device may measure electric, meangetic, optical and/or electromagnetic properties. Examples of measuring devices may be a Hall sensor, an impedance spectrometer, a resonance circuit, an oscilloscope (IV curve), a damping curve measurement via (mechanical induced) vibration of a battery cell, a measuring of diffusion of ions, a measuring mean free path of ions (charge carriers), a X-Ray, an electron spectroscopy, a mobility of charge carriers by virtual sensor (change of its natural/resonant frequency) due to degradation - LC resonator, etc. The gathering of the battery data may be provided by receiving, providing and/or determining the already existing battery data, e.g. by scanning an identification element being arranged on the housing of the battery and which itself may provide the battery data and/or which information can be used to gather/identify the battery data from a third source. For example, the gathered battery data are the name and the age of a respective battery. However, the battery data may comprise further information, e.g. information about the material classes contained therein (e.g. NCM, LFP), quality classes, manufacturer data, available measurement data, information about the previous use of the battery, e.g. number of charging cycles, weather and temperature data, information about previous charging currents and charging voltages.

The term reference battery data is to be understood broadly in the present case and refers to any data/information matching and/or corresponding to the gathered battery data indicating the chemical functionality and/or chemical property, e.g. composition, of the reference battery data. The reference battery data preferably comprises data of a reference battery representing the chemical and/or physical property, e.g. composition or property of the chemical ingredients, of the battery to be assessed over its lifetime and for different operating conditions.

The chemical functionality and/or chemical property, e.g. composition, may relate to the battery chemistry. The battery chemistry may relate to the electrode active material, such as the anode and/or cathode active material. The battery chemistry may degrade during use of the battery. The battery may be a battery in use. In such instances the state of the battery chemistry may be relevant with respect to further uses of the battery use, such as if it is still usable or if it has to be replaced. The battery may be a used battery, e.g. at its end-of-life. In such instances the state of the battery chemistry may be relevant with respect to second uses of the used or end-of-life battery. For example, the chemical functionality may relate to the degradation level of the battery. Further for example, the chemical property, e.g. composition, may relate to the material configuration of the battery, such as the electrode. The chemical property, e.g. composition, may relate to the electrode, e.g. anode or cathode, active material.

The term classification system used herein is to be understood broadly in the present case and represents any system, algorithm or determination means configured to determine a classification/execute classification methods. Classifications may be provided by classification methods, e.g. manual, automatic, numerical, non-numerical, statistical, non-distribution, supervised, unsupervised, permanently dimensioned, learning, parametric or non-parametric methods or the like.

The term battery identification element used herein is to be understood broadly in the present case allowing at least to identify the battery to be assessed. The battery identification element may be associated with the battery and physically attached to the battery housing. The battery identification element may be a passive identification element comprising a printed code such as a bar code or a QR code. The battery identification element may be an active identification element comprising a transmitter or transceiver tag, such as an RFID tag enabling communication through e.g. NFC, Bluetooth, ZigBee or other suitable near- to mid-range communication protocols.

The battery identification element may also be associated with a unique digital battery identifier which may be further associated with data relating to the identified battery, e.g. the above described battery data. Such data may include any data collected during the production or lifetime of the battery. For instance, such data may include material data collected during production of the battery or monitoring data collected during use of the battery may also be by associated with the digital battery identifier. The digital battery identifier may include at least one decentral identifier that allows for location-independent access to the described battery data which may be required due to the described data collection may take place at different locations worldwide. Such battery data may include the herein described already existing battery data and/or the battery data being measured utilizing one or more of the herein described contactless measurement techniques.

For such data access to the battery data, the decentral identifier may comprise any unique identifier uniquely associated with the data owner and the identified battery. The decentral identifier may include a Universally Unique IDentifier (UUID) or a Digital IDentifier (DID). The decentral identifier may be issued by a central or decentral identity issuer. The decentral identifier may include authentication information for authentication of the data relating to the identified battery. Via the decentral identifier and its unique association with the battery identified access to the data relating to the identified battery may be controlled by at least one data owner which may be located globally anywhere. This contrasts with central authority schemes, where identifiers are provided by central authority and access to data is controlled by such central authority. Decentral in this context refers to the usage of the identifier in implementation as controlled by any data owner. The identification element may be configured to provide the digital battery identifier for accessing data relating to the identified battery.

The term computing system is defined herein broadly as including one or more computing nodes, a system of nodes or combinations thereof. The term computing node is defined herein broadly and may refer to any device or system that includes at least one physical and tangible processor, and/or a physical and tangible memory capable of having thereon computer-executable instructions that are executed by a processor. Computing nodes are now increasingly taking a wide variety of forms. Computing nodes may, for example, be handheld devices, production facilities, sensors, monitoring systems, control systems, appliances, laptop computers, desktop computers, mainframes, data centers, or even devices that have not conventionally been considered a computing node, such as wearables (e.g., glasses, watches or the like). The memory may take any form and depends on the nature and form of the computing node.

In an embodiment of the method for determining a chemical functionality and/or chemical composition of a battery, the matching data are provided by classifying the battery on the basis of at least one parameter of the gathered battery data, finding matching reference batteries with respect to the at least one parameter, and identifying the data of the found matching reference batteries as to be the matching data. In an example, the parameter may indicate a battery type, wasting, a production date/time, load cycles, producer data, and/or the age of the battery.

In another embodiment of the method for determining a chemical functionality and/or chemical property, e.g. composition, of a battery, the finding of the matching reference batteries with respect to at least one parameter comprises providing data by a data service in an at least partially decentral computing environment, wherein the data service or interface accesses reference battery data.

The reference battery data may be gathered via a decentral computing environment or decentral network. The decentral computing environment or decentral network may include nodes associated with participants of the network. The nodes may comprise data providing or consuming interfaces configured for transferring data between nodes. The gathering of reference battery data may include: identifying or providing a digital identifier of the at least one battery, e.g. through the identification element such as reading the identification element, providing the digital identifier to the decentral computing or network interface for requesting reference battery data, and providing reference battery data to the decentral network or computing interface. The digital identifier may include the unique digital battery identifier or the decentral identifier associated with the battery. This way the battery specific reference data may be accessed for each battery, making the determination of the functionalities and/or properties of the battery more reliable and robust. In particular, reference battery data can be accessed by any participant of the network in a controlled manner, thus giving owners of the reference data such as battery of cell producers control over their data.

The battery reference data may be provided in relation to the identified battery or in relation to the identifier uniquely identifying the battery. The data transfer may include one or more authentication mechanism(s) associated with or linked to the decentral identifier associated with the identified battery or in relation to the identifier uniquely identifying the battery. Based on the authentication mechanism, such as a public-private-key mechanism, a peer-to-peer communication channel may be opened for providing the reference data, e.g. by a data providing interface associated with a reference data owner, such as a battery or cell producer. The data transfer may include one or more authorization mechanism(s) associated with or linked to the decentral identifier associated with the identified battery or in relation to the identifier uniquely identifying the battery. The one or more authorization mechanism(s) may include at least one authorization rule for controlling access to data under control by the data owners, e.g. battery producers or cell producers. Based on the authorization mechanism(s), the reference data may be transferred from the reference data providing interface to the reference data consuming interface. The reference data consuming interface may be the decentral network interface for requesting reference battery data.

The battery reference data may be provided in relation to the at least one parameter for the matching reference batteries. The parameter may be provided together with the identifier to a decentral computing or network interface for requesting reference battery data. Based on the parameter, the reference data may be selected. The battery references data provided by the reference data provider may be selected based on the at least one parameter. The at least one parameter may for example relate to the property measurement device and/or the property measured by the property measurement device. Thus, reference data selected based on the parameter may be provided. This allows for more flexible and reliable handling of the reference data and the available battery data. This allows for more reliable determination since reference data for the battery in view of the specific battery and the available parameters, such as types of property measurement devices and/or properties measured by the property measurement device, can be provided and used for determination, matching, and/or classification.

In one example, different suppliers, battery manufacturers or other entities that perform battery tests and/or measurements can provide corresponding battery data here, so that the corresponding reference data is available in a decentralized manner at the respective entities. The herein described decentralized approach thus has the advantage that such reference battery data can be accessed independently of the location of a data requestor, namely by means of the described unique identifier. The decentralized approach has the advantage of enabling the reference data retrieval for different measurement techniques and associated parameters and can hence provide the reference data in a targeted manner. This leads to more reliable determination of chemical functionality and/or chemical composition of a battery as well as matching or classification.

In another embodiment of the method for determining a chemical functionality and/or chemical composition of a battery, the matching data are provided by classifying the battery on basis of at least one parameter of the gathered battery data, finding matching reference batteries with respect to the at least one parameter by using a model, in particular a prediction model, which simulates a behavior of a reference battery with respect to the at least one parameter, and identifying the data of the found matching reference batteries as to be the matching data. Such models may be based on a digital twin of an underlying battery and/or battery cells.

In another embodiment of the method for determining a chemical functionality and/or chemical composition of a battery, the matching data are provided by classifying the battery on basis of at least one parameter of the gathered battery data, finding matching reference batteries with respect to the at least one parameter by using a machine learning, ML, system, and identifying the data of the found matching reference batteries as to be the matching data.

In another embodiment of the method for determining a chemical functionality and/or chemical composition of a battery, the classifying of the battery is provided by using a machine learning, ML, model by collecting a plurality of battery data, manual deciding on a use of the battery based on the battery data, combining the collected battery data and the manual decision on the use of the battery, identifying and defining the factors leading to the manual decision, evaluating the identified and defined factors by applying them to further batteries and possibly adapting the factors if the evaluation indicates inconsistencies, and providing the classification of the battery by applying the factors on the gathered battery data.

In another embodiment of the method for determining a chemical functionality and/or chemical composition of a battery, the method further comprises a classifying of the battery based on the functionality and/or composition data in a plurality of classes, wherein each class specifies a use of the battery.

In another embodiment of the method for determining a chemical functionality and/or chemical composition of a battery, the plurality of classes includes at least one class for a further use of the battery and/or at least one class for recycling of the battery. Such further use can be, for example, the use as car battery, energy storage cell connected to solar cells, E-scooter battery, E-bike battery, power-tool battery, mobile device battery, e.g. mobile phone, notebook, laptop, power bank, tablet, etc.

In another embodiment of the method for determining a chemical functionality and/or chemical composition of a battery, the method further comprises the step of providing the determined functionality and/or composition data, matching data and/or the classification data in relation to a unique digital identifier associated with the battery. The determined data may be provided in relation to a unique identifier of the battery. For example the unique digital identifier of the battery may be provided by a QR code, hologram, microchip, NFC-chip, RFID -chip.

In an embodiment of the system for determining a chemical functionality and/or chemical composition of a battery, the providing unit comprises at least one reference battery database, a model, and/or a machine learning, ML, model.

In another embodiment of the system for determining a chemical functionality and/or chemical composition of a battery, the system further comprises at least one classification unit for classifying the battery based on the functionality and/or composition data in a plurality of classes and/or for classifying the battery on basis of at least one parameter of the gathered battery data.

In another embodiment the matching data are provided by classifying the battery on basis of at least one parameter of the gathered battery data, finding matching reference batteries with respect to the at least one parameter by using a model, in particular a prediction model, which simulates a behavior of a reference battery with respect to the at least one parameter, and identifying the data of the found matching reference batteries as to be the matching data.

In another embodiment the matching data are provided by classifying the battery on basis of at least one parameter of the gathered battery data, finding matching reference batteries with respect to the at least one parameter by using a machine learning, ML, system, and identifying the data of the found matching reference batteries as to be the matching data.

In another embodiment the classifying of the battery is provided by using a machine learning, ML, model by collecting a plurality of battery data, manual deciding on a use of the battery based on the battery data, combining the collected battery data and the manual decision on the use of the battery, identifying and defining the factors leading to the manual decision, evaluating the identified and defined factors by applying them to further batteries and possibly adapting the factors if the evaluation indicates inconsistencies, and providing the classification of the battery by applying the factors on the gathered battery data.

### BRIEF DESCRIPTION OF THE DRAWINGS

In the following, the present disclosure is further described with reference to the enclosed figures:
- Fig. 1: illustrates schematically a battery with a battery identification element;
- Fig. 2: illustrate example embodiments of a centralized computing environment with computing nodes;
- Fig. 3: illustrate example embodiments of a decentralized computing environment with computing nodes;
- Fig. 4: illustrates an example embodiment of a distributed computing environment;
- Fig. 5: illustrates a block diagram of an example system architecture of a system for determining a chemical functionality and/or chemical composition of a battery;
- Fig. 6: illustrates a flow diagram of a computer-implemented method for determining a chemical functionality and/or chemical composition of a battery;
- Fig. 7: illustrates a flow diagram of a further computer-implemented method for determining a chemical functionality and/or chemical composition of a battery;
- Fig. 8: illustrates a flow diagram of a further computer-implemented method for determining a chemical functionality and/or chemical composition; and
- Fig. 9: illustrates a flow diagram of a further computer-implemented method for determining a chemical functionality and/or chemical composition of a battery.

### DETAILED DESCRIPTION OF EMBODIMENT

The following embodiments are mere examples for implementing the method, the system or application device disclosed herein and shall not be considered limiting.

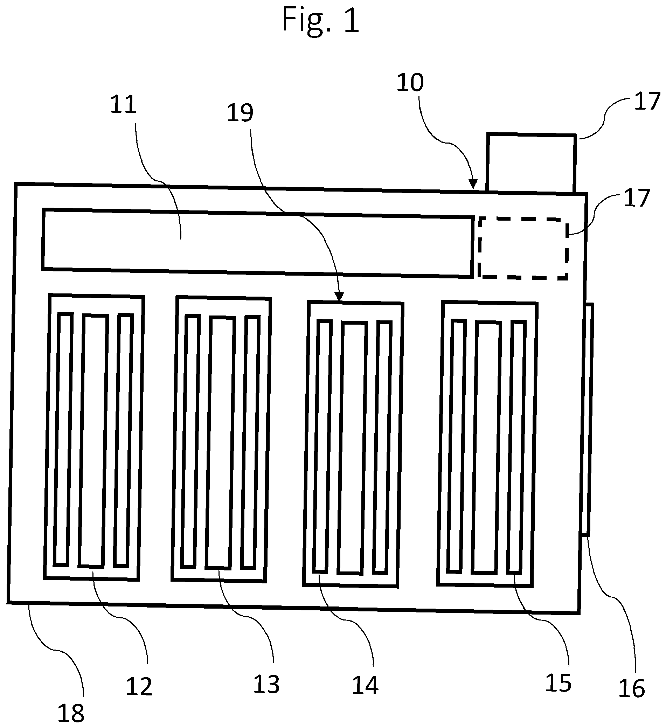

Fig. 1 illustrates schematically a battery 10 with battery identification elements 16, 17. The battery 10 may comprise a battery management system 11 and a plurality of battery cells 19 arranged inside a battery housing 18. The battery cells 19 may be arranged in battery packs or modules comprising multiple battery cells. The battery cell 19 may comprise an electrolyte 12, an anode 14, a cathode 15, and a separator 13.

The battery identification element 16, 17 may be associated with the battery 10. The battery identification element 16, 17 may be physically attached to the battery housing. The battery identification element 16, 17 may be arranged inside or outside the battery housing 18. The battery identification element 16, 17 may be a passive identification element 16. The passive element 16 may be arranged on the outer surface of the battery housing 18. The passive element 16 may include a printed code such as a bar code or a QR code. The battery identification element 16, 17 may be an active identification element 17. The active element 17 may be a transmitter or transceiver tag, such as an RFID tag enabling communication through e.g. NFC, Bluetooth, ZigBee or other suitable near- to mid-range communication protocols. The battery identification element 17 may be part of the battery management system 11 or the digital battery identifier may be stored in the battery management system 11.

The battery identification element 16, 17 may be associated with a digital battery identifier. The digital battery identifier may be unique for the battery. The digital battery identifier may be further associated with data relating to the identified battery. Such data may include any data collected during the production or lifetime of the battery. For instance, such data may include material data collected during production of the battery or monitoring data collected during use of the battery may be by associated with the digital battery identifier.

The digital battery identifier may include at least one decentral identifier. Decentral identifier may comprise any unique identifier uniquely associated with the data owner and the identified battery. The decentral identifier may include a Universally Unique IDentifier (UUID) or a Digital IDentifier (DID). The decentral identifier may be issued by a central or decentral identity issuer. The decentral identifier may include authentication information for authentication of the data relating to the identified battery. Via the decentral identifier and its unique association with the battery identified access to the data relating to the identified battery may be controlled by at least one data owner. This contrasts with central authority schemes, where identifiers are provided by central authority and access to data is controlled by such central authority. Decentral in this context refers to the usage of the identifier in implementation as controlled by any data owner, in particular independently of his/her location. The identification element 16, 17 may be configured to provide the digital battery identifier for accessing data relating to the identified battery.

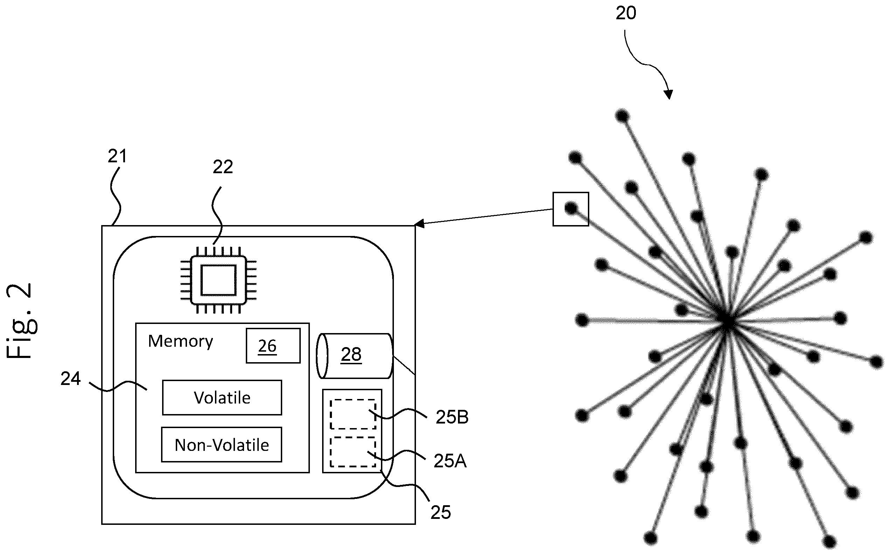

Figs. 2 to 4 illustrate different computing environments, central, decentral and distributed. The methods, apparatuses, systems, computer elements of this disclosure may be implemented in decentral or at least partially decentral computing environments. In particular, providing of data may be realized by different computing nodes, which may be implemented in a centralized, a decentralized or a distributed computing environment thus allowing the described location independent data access. Furthermore, determination of data may be realized by different computing nodes, which may be implemented in a centralized, a decentralized, or a distributed computing environment.

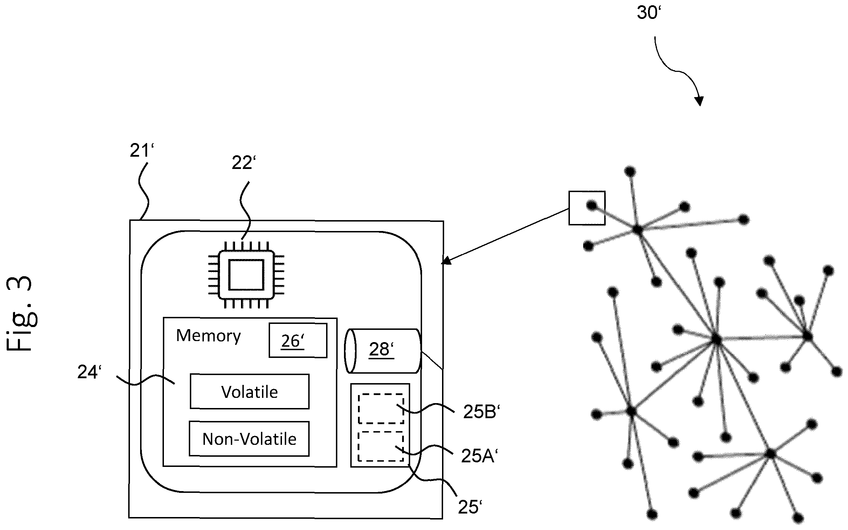

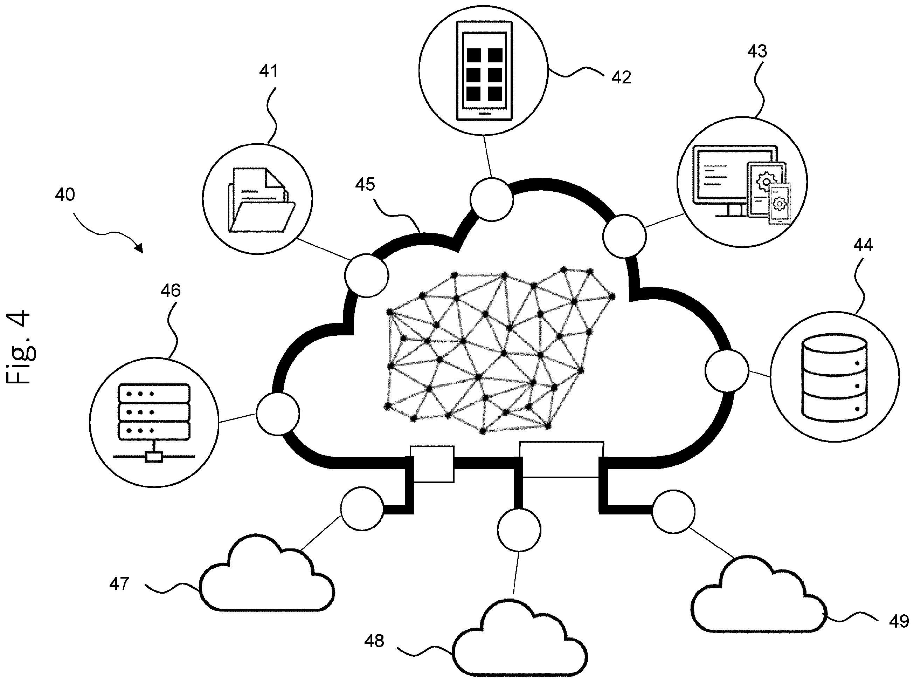

Figs. 2 and 3 illustrate example embodiments of a centralized and a decentralized computing environment with computing nodes. Fig. 4 illustrates an example embodiment of a distributed computing environment.

Fig. 2 illustrates an example embodiment of a centralized computing system 20 comprising a central computing node 21 (filled circle in the middle) and several peripheral computing nodes 21.1 to 21.n (denoted as filled circles in the periphery). The term "computing system" is defined herein broadly as including one or more computing nodes, a system of nodes or combinations thereof. The term "computing node" is defined herein broadly and may refer to any device or system that includes at least one physical and tangible processor, and/or a physical and tangible memory capable of having thereon computer-executable instructions that are executed by a processor. Computing nodes are now increasingly taking a wide variety of forms. Computing nodes may, for example, be handheld devices, production facilities, sensors, monitoring systems, control systems, appliances, laptop computers, desktop computers, mainframes, data centers, or even devices that have not conventionally been considered a computing node, such as wearables (e.g., glasses, watches or the like). The memory may take any form and depends on the nature and form of the computing node.

In this example, the peripheral computing nodes 21.1 to 21.n may be connected to one central computing system (or server). In another example, the peripheral computing nodes 21.1 to 21.n may be attached to the central computing node via e.g. a terminal server (not shown). The majority of functions may be carried out by, or obtained from the central computing node (also called remote centralized location). One peripheral computing node 21.n has been expanded to provide an overview of the components present in the peripheral computing node. The central computing node 21 may comprise the same components as described in relation to the peripheral computing node 21.n.

Each computing node 21, 21.1 to 21.n may include at least one hardware processor 22 and memory 24. The term "processor" may refer to an arbitrary logic circuitry configured to perform basic operations of a computer or system, and/or, generally, to a device which is configured for performing calculations or logic operations. In particular, the processor, or computer processor may be configured for processing basic instructions that drive the computer or system. It may be a semiconductor-based processor, a quantum processor, or any other type of processor configures for processing instructions. As an example, the processor may comprise at least one arithmetic logic unit ("ALU"), at least one floating-point unit ("FPU"), such as a math coprocessor or a numeric coprocessor, a plurality of registers, specifically registers configured for supplying operands to the ALU and storing results of operations, and a memory, such as an L1 and L2 cache memory. In particular, the processor may be a multicore processor. Specifically, the processor may be or may comprise a Central Processing Unit ("CPU"). The processor may be a ("GPU") graphics processing unit, ("TPU") tensor processing unit, ("CISC") Complex Instruction Set Computing microprocessor, Reduced Instruction Set Computing ("RISC") microprocessor, Very Long Instruction Word ("VLIW") microprocessor, or a processor implementing other instruction sets or processors implementing a combination of instruction sets. The processing means may also be one or more special-purpose processing devices such as an Application-Specific Integrated Circuit ("ASIC"), a Field Programmable Gate Array ("FPGA"), a Complex Programmable Logic Device ("CPLD"), a Digital Signal Processor ("DSP"), a network processor, or the like. The methods, systems and devices described herein may be implemented as software in a DSP, in a micro-controller, or in any other side-processor or as hardware circuit within an ASIC, CPLD, or FPGA. It is to be understood that the term processor may also refer to one or more processing devices, such as a distributed system of processing devices located across multiple computer systems (e.g., cloud computing), and is not limited to a single device unless otherwise specified.

The memory 24 may refer to a physical system memory, which may be volatile, non-volatile, or a combination thereof. The memory may include non-volatile mass storage such as physical storage media. The memory may be a computer-readable storage media such as RAM, ROM, EEPROM, CD-ROM, or other optical disk storage, magnetic disk storage, or other magnetic storage devices, non-magnetic disk storage such as solid-state disk or any other physical and tangible storage medium which can be used to store desired program code means in the form of computer-executable instructions or data structures and which can be accessed by the computing system. Moreover, the memory may be a computer-readable media that carries computer- executable instructions (also called transmission media). Further, upon reaching various computing system components, program code means in the form of computer-executable instructions or data structures can be transferred automatically from transmission media to storage media (or vice versa). For example, computer-executable instructions or data structures received over a network or data link can be buffered in RAM within a network interface module (e.g., a "NIC"), and then eventually transferred to computing system RAM and/or to less volatile storage media at a computing system. Thus, it should be understood that storage media can be included in computing components that also (or even primarily) utilize transmission media.

The computing nodes 21, 21.1 to 21.n may include multiple structures 26 often referred to as an "executable component, executable instructions, computer-executable instructions or instructions". For instance, memory 24 of the computing nodes 21, 21.1 to 21.n may be illustrated as including executable component 26. The term "executable component" or any equivalent thereof may be the name for a structure that is well understood to one of ordinary skill in the art in the field of computing as being a structure that can be software, hardware, or a combination thereof or which can be implemented in software, hardware, or a combination. For instance, when implemented in software, one of ordinary skill in the art would understand that the structure of an executable component includes software objects, routines, methods, and so forth, that is executed on the computing nodes 21, 21.1 to 21.n, whether such an executable component exists in the heap of a computing node 21, 21.1 to 21.n, or whether the executable component exists on computer-readable storage media. In such a case, one of ordinary skill in the art will recognize that the structure of the executable component exists on a computer-readable medium such that, when interpreted by one or more processors of a computing node 21, 21.1 to 21.n (e.g., by a processor thread), the computing node 21, 21.1 to 21n is caused to perform a function. Such a structure may be computer-readable directly by the processors (as is the case if the executable component were binary). Alternatively, the structure may be structured to be interpretable and/or compiled (whether in a single stage or in multiple stages) so as to generate such binary that is directly interpretable by the processors. Such an understanding of example structures of an executable component is well within the understanding of one of ordinary skill in the art of computing when using the term "executable component". Examples of executable components implemented in hardware include hardcoded or hard-wired logic gates, that are implemented exclusively or near-exclusively in hardware, such as within a field- programmable gate array (FPGA), an application-specific integrated circuit (ASIC), or any other specialized circuit. In this description, the terms "component", "agent", "manager", "service", "engine", "module", "virtual machine" or the like are used synonymous with the term "executable component.

The processor 22 of each computing node 21, 21.1 to 21.n may direct the operation of each computing node 21, 21.1 to 21.n in response to having executed computer-executable instructions that constitute an executable component. For example, such computer-executable instructions may be embodied on one or more computer-readable media that form a computer program product. The computer-executable instructions may be stored in the memory 24 of each computing node 21, 21.1 to 21.n. Computer-executable instructions comprise, for example, instructions and data which, when executed at a processor 21, cause a general-purpose computing node 21, 21.1 to 21.n, special purpose computing node 21, 21.1 to 21.n, or special purpose processing device to perform a certain function or group of functions. Alternatively, or in addition, the computer-executable instructions may configure the computing node 21, 21.1 to 21.n to perform a certain function or group of functions. The computer executable instructions may be, for example, binaries or even instructions that undergo some translation (such as compilation) before direct execution by the processors, such as intermediate format instructions such as assembly language, or even source code.

Each computing node 21, 21.1 to 21.n may contain communication channels 28 that allow each computing node 21.1 to 21.n to communicate with the central computing node 21, for example, a network (depicted as solid line between peripheral computing nodes and the central computing node in Fig. 2). A "network" may be defined as one or more data links that enable the transport of electronic data between computing nodes 21, 21.1 to 21.n and/or modules and/or other electronic devices. When information is transferred or provided over a network or another communications connection (either hardwired, wireless, or a combination of hardwired or wireless) to a computing node 21, 21.1 to 21.n, the computing node 21, 21.1 to 21.n properly views the connection as a transmission medium. Transmission media can include a network and/or data links which can be used to carry desired program code means in the form of computer-executable instructions or data structures and which can be accessed by a general-purpose or special-purpose computing nodes 21, 21.1 to 21.n. Combinations of the above may also be included within the scope of computer-readable media.

The computing node(s) 21, 21.1 to 21.n may further comprise a user interface system 25 for use in interfacing with a user. The user interface system 25 may include output mechanisms 25A as well as input mechanisms 25B. The principles described herein are not limited to the precise output mechanisms 25A or input mechanisms 25B as such will depend on the nature of the device. However, output mechanisms 25A might include, for instance, displays, speakers, displays, tactile output, holograms and so forth. Examples of input mechanisms 25B might include, for instance, microphones, touchscreens, holograms, cameras, keyboards, mouse or other pointer input, sensors of any type, and so forth.

Fig. 3 illustrates an example embodiment of a decentralized computing environment 30 with several computing nodes 21.1 to 21.n denoted as filled circles. In contrast to the centralized computing environment 20 illustrated in Fig. 2, the computing nodes 21.1 to 21.n of the decentralized computing environment are not connected to a central computing node 21 and are thus not under control of a central computing node. Instead, resources, both hardware and software, may be allocated to each individual computing node 21.1 to 21.n (local or remote computing system) and data may be distributed among various computing nodes 21.1 to 21.n to perform the tasks. Thus, in a decentral system environment, program modules may be located in both local and remote memory storage devices thus enabling the described location independent data access. One computing node 21 has been expanded to provide an overview of the components present in the computing node 21. In this example, the computing node 21 comprises the same components as described in relation to Fig. 2.

Fig. 4 illustrates an example embodiment of a distributed computing environment 40. In this description, "distributed computing" may refer to any computing that utilizes multiple computing resources. Such use may be realized through virtualization of physical computing resources. One example of distributed computing is cloud computing. "Cloud computing" may refer a model for enabling on-demand network access to a shared pool of configurable computing resources (e.g., networks, servers, storage, applications, and services). When distributed, cloud computing environments may be distributed internationally within an organization and/or across multiple organizations. In this example, the distributed cloud computing environment 40 may contain the following computing resources: mobile device(s) 42, applications 43, databases 44, data storage and server(s) 46. The cloud computing environment 40 may be deployed as public cloud 47, private cloud 48 or hybrid cloud 49. A private cloud 47 may be owned by an organization and only the members of the organization with proper access can use the private cloud 48, rendering the data in the private cloud at least confidential. In contrast, data stored in a public cloud 48 may be open to anyone over the internet. The hybrid cloud 49 may be a combination of both private and public clouds 47, 48 and may allow to keep some of the data confidential while other data may be publicly available.

Referring back to Fig. 1, the battery or battery component identifiers provided by the identification element 16, 17 may be processed in an at least partially decentralized computing environment. Battery or battery component identifiers may be configured to access battery or battery component data, such as material data. Further decentral identifiers may be associated with recycling or production plants participating in the recycling or production of batteries thus enabling the described location independent data access. Recycling or production plant identifiers may be configured to access recycling or production plant data, such as capacity data, process specific data or operator data. By associating such decentral identifiers to authentication information and optionally authorization rules data can be shared securely and reliably across players or systems of the production and/or recycling chain.

The above at least partially decentralized structure based on decentral identifiers allows for novel methods, apparatuses, systems, computer elements, computer executable instructions and their uses in the battery recycling process, which will be described in the following.

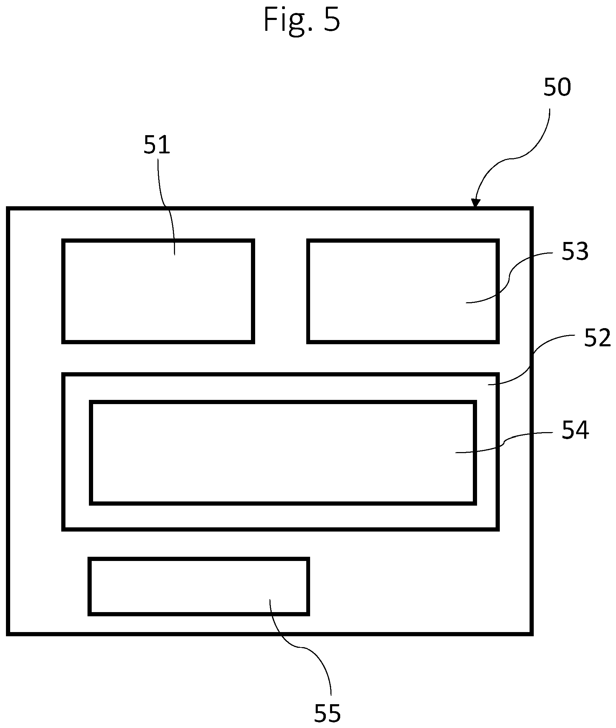

Fig. 5 illustrates a block diagram of an example system architecture of a system for determining a chemical functionality and/or chemical composition of a battery. The system 50 for determining a chemical functionality and/or chemical composition of a battery comprises a gathering unit 51 being configured to gathering battery data indicating at least one chemical and/or physical property of the chemical ingredients of the battery. The gathering unit 51 is a unit that receives, provides and/or determines the battery data based on already existing data or on non-existing data being measured preferably by an above-mentioned property measuring device, e.g. information of a label on the battery or information from previously made measurements. The battery data indicate at least one chemical and/or physical property of the chemical ingredients of the battery. The gathering unit 51 may be at least one of a Hall sensor, an impedance spectrometer, a resonance circuit, an oscilloscope (IV curve), a damping curve measurement via (mechanical induced) vibration of a battery cell, a measuring of diffusion of ions, a measuring mean free path of ions (charge carriers), a X-Ray, an electron spectroscopy, a mobility of charge carriers by virtual sensor (change of its natural/resonant frequency) due to degradation - LC resonator). The gathering unit 51 provides gathering battery data for further processing to the system 50. The system 50 further comprises a providing unit 52 being configured for providing matching data by determining at least one matching between the gathered battery data and data of a reference battery. The providing unit 52 receives the gathered battery data from the gathering unit 51, uses these data in order to determine matching data, and provides the matching data for further processing/uses to the system 50. The system 50 further comprises a determination unit 53 for determining functionality and/or composition data indicating the chemical functionality and/or chemical composition of the battery based on the matching data. The determination unit 53 receives the matching data from the providing unit 52 and uses these data in order to determine the functionality and/or composition data. The providing unit 52 comprises a reference battery database 54 including data of at least one reference battery. Additionally and/or alternatively a model or a machine learning system can be included in the providing unit 52 for providing data of at least one reference battery. The system 50 further comprises at least one classification unit 55 for classifying the battery based on the functionality and/or composition data in a plurality of classes and/or for classifying the battery on basis of at least one parameter of the gathered battery data. The classification unit 55 receives the functionality and/or composition data and classifies these data in a plurality of different classes. The results of the classification can be provided/outputted by the classification unit 55 for further processing to the system 50.

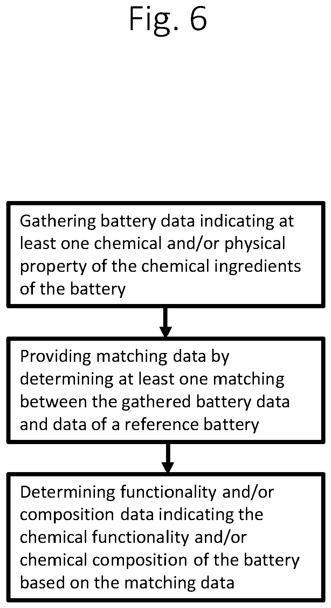

Fig. 6 illustrates a flow diagram of a computer-implemented method for determining a chemical functionality and/or chemical composition of a battery. In a first step, battery data indicating at least one chemical and/or physical property of the chemical ingredients of the battery are gathered, wherein the battery data are already existing data. The gathering of the battery data is provided by receiving, providing and/or determining the already existing battery data or measured data being measured by means of a Hall sensor. Exemplary, in the latter case, the gathered battery data may be the strength and the direction of the magnetic field measured by the Hall sensor. In case of already existing battery data, the gathering may be performed by scanning an identification element being arranged on the housing of the battery. In the latter case, the gathered battery data may be the name and the age of a battery. In a second step, matching data indicating a matching between the gathered battery data from the first step and data of a reference battery are provided by determination. The matching data include the gathered battery data, the matching counterpart to the gathered battery data, i.e. the reference battery data matching to the gathered battery data, probably an matching index, e.g. a correlation, of the gathered battery data to the reference battery data, and the functionality and/or composition data of the reference battery indicating the chemical functionality and/or chemical composition of the reference battery. Both the reference battery data and the functionality and/or composition data of the reference battery are included in the data of a reference battery. With respect to the above-mentioned example, in the second step, in case of the mentioned existing data, the name and the age of the battery are matched to a reference battery having the same name and same age, wherein the resulting matching data includes the name and the age of the battery, the name and the age of a reference battery, a correlation value of "1", and the functionality and/or composition data of the reference battery. In case of additionally measured data, the strength and the direction of the magnetic field of the battery may be matched to a reference battery having the same strength and the direction of the magnetic field, wherein the resulting matching data of this matching includes the strength and direction of the magnetic field of the battery, the strength and direction of the magnetic field of the reference battery, a correlation value of "1", and the functionality and/or composition data of the reference battery. In a third step, functionality and/or composition data indicating the chemical functionality and/or chemical composition of the battery are determined based on the matching data. Since, in the second step, the provided matching data includes the functionality and/or composition data of the reference battery, the determination is an assumption that the functionality and/or composition data of the reference battery equals to the functionality and/or composition data of the battery, when the matching between the gathered battery data and data of a reference battery exists. With respect to the above-mentioned example, when the age and the name of the battery and the reference battery corresponds to each other, and/or when the strength and the direction of the magnetic field of the battery and the reference battery corresponds to each other, it is assumed that the functionality and/or composition data of the reference battery equals to the functionality and/or composition data of the battery.

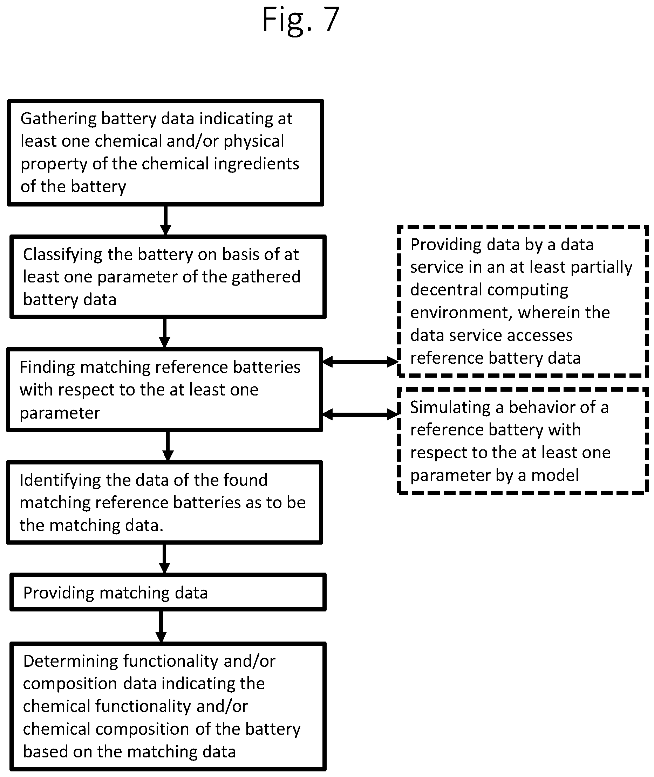

Fig. 7 illustrates a flow diagram of a further computer-implemented method for determining a chemical functionality and/or chemical composition of a battery of Fig. 6. The second step of providing matching data includes a plurality of sub steps. A first sub step is to classify the battery on basis of at least one parameter of the gathered battery data. The parameter can be freely chosen and include e.g. the name and/or the age of the battery. A second sub step is to find matching reference batteries with respect to the at least one parameter. In this second sub step, the matching of reference batteries to the battery is provided by comparing the chosen at least one parameter of the battery to the parameters of reference batteries and identifying at least one comparison in which the at least one parameters of the reference batteries and the battery matches. A third sub step is to identifying the data of the found matching reference batteries as to be the matching data. In this third sub step, the matching data are provided by choosing the reference battery matching with the chosen parameters of the battery and taking the functionality and/or composition data of this reference battery. In a fourth sub step the matching data are provided for further processing.

Optionally, the second sub step of the step providing matching data includes providing data by a data service in an at least partially decentral computing environment, wherein the data service accesses reference battery data. Alternatively, or in addition, this step may include querying data from at least one reference battery database. A querying may be provided by gathering information of the database, sending information transmitting instruction to the database and receiving corresponding answers from the database, and/or directly accessing on the database.

Optionally, the second sub step of the step providing matching data includes simulating a behaviour of a reference battery with respect to the at least one parameter by a model. A simulation is provided by a forward model or prediction model. The simulation has the chosen at least one parameter as an input and calculates a behavior of a reference battery, i.e. the functionality and/or composition data of the reference battery, on the basis of non-linear, partial and/or linear differential equations.

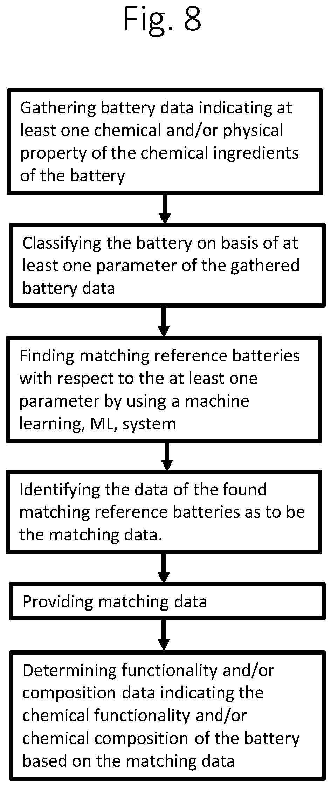

Fig. 8 illustrates a flow diagram of a further computer-implemented method for determining a chemical functionality and/or chemical composition of a battery of Fig. 7. Beside the steps and sub steps of Fig. 7, the second sub step of the step providing matching data includes finding of matching reference batteries with respect to the at least one parameter by using a machine learning, ML, system.

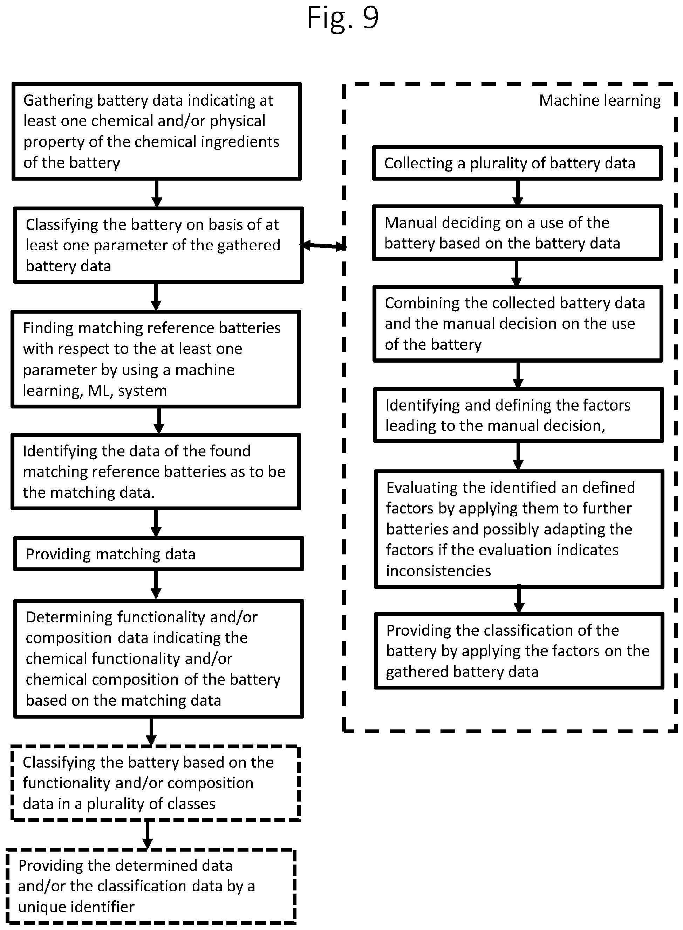

Fig. 9 illustrates a flow diagram of a further computer-implemented method for determining a chemical functionality and/or chemical composition of a battery of Fig. 7. Beside the steps and sub steps of Fig. 7, the first sub step of the step providing matching data includes classifying the battery on basis of at least one parameter of the gathered battery data by a machine learning system. The machine learning comprises the steps of collecting a plurality of battery data, manual deciding on a use of the battery based on the battery data, combining the collected battery data and the manual decision on the use of the battery, iidentifying and defining the factors leading to the manual decision, evaluating the identified an defined factors by applying them to further batteries and possibly adapting the factors if the evaluation indicates inconsistencies, and pproviding the classification of the battery by applying the factors on the gathered battery data.

Optionally, the further computer-implemented method for determining a chemical functionality and/or chemical composition of a battery of Fig. 9 comprises the further step of classifying the battery based on the functionality and/or composition data in a plurality of classes. Each class of the plurality of classes specifies a use or further use of the battery. Use or a further use is a 2^{nd} life of the battery and/or the class recycling of the battery.

Optionally, the further computer-implemented method for determining a chemical functionality and/or chemical composition of a battery of Fig. 9 comprises the further step of providing the determined data and/or the classification data by a unique identifier. The unique identifier is a QR code, hologram, microchip, NFC-chip, RFID-chip.

The present disclosure has been described in conjunction with exemplary preferred embodiments. However, other variations can be understood and effected by those persons skilled in the art and practicing the claimed invention, from the studies of the drawings, this disclosure and the claims. Notably, in particular, the any steps presented can be performed in any order, i.e. the present invention is not limited to a specific order of these steps. Moreover, it is also not required that the different steps are performed at a certain place or at one node of a distributed system, i.e. each of the steps may be performed at a different nodes using different equipment/data processing units.

In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A computer-implemented method for determining a chemical functionality and/or chemical composition of a battery, the method comprising:
- gathering battery data indicating at least one chemical and/or physical property related to the chemical ingredients of the battery;
- providing matching data by determining at least one matching between the gathered battery data and data of a reference battery,
wherein the matching data are provided by classifying the battery on the basis of at least one parameter of the gathered battery data, finding matching reference batteries with respect to the at least one parameter, and identifying the data of the found matching reference batteries as to be the matching data,
wherein the finding of the matching reference batteries with respect to at least one parameter comprises providing data by a data service in an at least partially decentral computing environment, wherein the data service accesses reference battery data,
wherein reference battery data is gathered via a decentral computing environment, wherein the gathering of reference battery data includes: providing a digital identifier of the battery, providing the digital identifier to a decentral computing interface configured to request reference battery data, and providing reference battery data to the decentral computing interface configured to request reference battery data; and
- determining functionality and/or composition data indicating the chemical functionality and/or chemical composition of the battery based on the matching data.

2. The method according to claim 1, wherein the battery reference data is provided in relation to the identified battery or in relation to the identifier uniquely identifying the battery.

3. The method according to claims 1 or 2, wherein the transfer of battery reference data includes one or more authentication mechanism(s) and/or authorization mechanism(s) associated with or linked to the identified battery or in relation to the identifier uniquely identifying the battery.

4. The method according to any one of the preceding claims, wherein the at least one parameter is provided together with the identifier to a decentral computing interface for requesting reference battery data, wherein the battery reference data is provided in relation to the at least one parameter for the matching reference batteries.

5. The method according to any one of the preceding claims, the method further comprises a classifying of the battery based on the functionality and/or composition data in a plurality of classes, wherein each class specifies a use of the battery, wherein the plurality of classes preferably includes at least one class for a further use of the battery and/or at least one class for recycling of the battery, wherein the method further comprises the step of providing the determined functionality and/or composition data, matching data and/or the classification data in relation to a unique identifier associated with the battery.

6. A system for determining a chemical functionality and/or chemical composition of a battery, the system comprising:
- a gathering unit for gathering battery data indicating at least one chemical and/or physical property of the chemical ingredients of the battery;
a providing unit for providing matching data by determining at least one matching between the gathered battery data and data of a reference battery,
wherein the matching data are provided by classifying the battery on the basis of at least one parameter of the gathered battery data, finding matching reference batteries with respect to the at least one parameter, and identifying the data of the found matching reference batteries as to be the matching data.
wherein the finding of the matching reference batteries with respect to at least one parameter comprises providing data by a data service in an at least partially decentral computing environment, wherein the data service accesses reference battery data.
- wherein reference battery data is gathered via a decentral computing environment, wherein the gathering of reference battery data includes: providing a digital identifier of the battery, providing the digital identifier to a decentral computing interface configured to request reference battery data, and providing reference battery data to the decentral computing interface configured to request reference battery data; and
- a determination unit for determining functionality and/or composition data indicating the chemical functionality and/or chemical composition of the battery based on the matching data.

7. The system according to claim 6, wherein the providing unit comprises at least one reference battery database, a model, and/or a machine learning, ML, model.

8. The system according to claim 6 or 7, wherein the system further comprises at least one classification unit for classifying the battery based on the functionality and/or composition data in a plurality of classes and/or for classifying the battery on basis of at least one parameter of the gathered battery data.

9. Use of battery data and/or chemical functionality data of a battery and/or chemical composition data of a battery in a method according to any one of claims 1 to 5.

10. Use of functionality and/or composition data determined by a method according to any one of claims 1 to 5 for classification and/or sorting of batteries.

11. Computer program element with instructions, which, when executed on computing devices of a computing environment, is configured to carry out the steps of the method according to any one of the claims 1 to 5 in a system according to any one of the claims 6 to 8.

12. Use of functionality and/or composition data and/or matching data according to any one of the claims 1 to 5 in a system according to any one of the claims 6 to 8 for deciding between a recycling or a second or further use of a battery.

## Patentansprüche

1. Eine computerimplementierte Methode zur Bestimmung einer chemischen Funktionalität und/oder chemischen Zusammensetzung einer Batterie, die Methode umfasst:
- das Sammeln von Batteriedaten, die mindestens eine chemische und/oder physikalische Eigenschaft im Zusammenhang mit den chemischen Bestandteilen der Batterie betreffen;
- Bereitstellung von Matching-Daten, indem mindestens eine
Übereinstimmung zwischen den gesammelten Batteriedaten und Daten einer Referenzbatterie bestimmt wird,
wobei die Abgleichsdaten durch die Klassifizierung der Batterie auf der Grundlage von mindestens einen Parameter der gesammelten Batteriedaten zu finden,
passende Referenzbatterien bezüglich des mindestens einen Parameters zu finden und die Daten der gefundenen passenden Referenzbatterien als die passenden Daten zu identifizieren,
wobei das Finden der passenden Referenzbatterien bezüglich mindestens eines Parameters die Bereitstellung von Daten durch einen Datendienst mindestens teilweise beinhaltet
dezentrale Rechenumgebung, in der der Datendienst auf Referenzbatteriedaten zugreift,
wobei Referenzbatteriedaten über eine dezentrale Rechenumgebung erhoben werden, wobei die Erfassung der Referenzbatteriendaten Folgendes umfasst:
Bereitstellung eines digitalen Identifikators der Batterie, die Bereitstellung der digitalen Kennung an eine dezentrale Rechenschnittstelle, die so konfiguriert ist, dass Referenzbatteriedaten angefordert werden, und Referenzbatteriendaten an die dezentrale Rechenschnittstelle, die so konfiguriert ist, dass Referenzbatteriendaten angefordert wird; und
- Bestimmung von Funktions- und/oder Zusammensetzungsdaten, die die chemische Funktionalität und/oder chemische Zusammensetzung der Batterie anhand des Abgleichs angeben
Daten.

2. Die Methode gemäß Anspruch 1, bei der die Batteriereferenzdaten in Bezug auf die identifizierte Batterie oder in Bezug auf den Identifikator, der die Batterie eindeutig identifiziert, bereitgestellt werden.

3. Die Methode gemäß Ansprüchen 1 oder 2, bei der die Übertragung von Batteriereferenzdaten einen oder mehrere Authentifizierungsmechanismen und/oder Autorisierungsmechanismen umfasst, die mit der identifizierten Batterie oder in Bezug auf die eindeutige Identifikation der Batterie verknüpft sind.

4. Die Methode gemäß einer der vorangegangenen Ansprüche, bei der mindestens ein Parameter zusammen mit dem Identifikator einer dezentralen Rechenschnittstelle zur Abfrage von Referenzbatteriedaten bereitgestellt wird, wobei die Batteriereferenzdaten in Bezug auf mindestens einen Parameter für die passenden Referenzbatterien bereitgestellt werden.

5. Die Methode umfasst gemäß einer der vorangegangenen
Ansprüche außerdem eine Klassifikation der Batterie basierend auf Funktionalitäts- und/oder Zusammensetzungsdaten in einer Vielzahl von Klassen, wobei jede Klasse eine Verwendung der Batterie angibt, wobei die Vielzahl der Klassen vorzugsweise mindestens eine Klasse für eine weitere umfasst Verwendung der Batterie und/oder mindestens einer Klasse zum Recycling der Batterie, wobei die Methode außerdem den Schritt umfasst, die bestimmte Funktionalität und/oder Zusammensetzungsdaten bereitzustellen, Daten und/oder die Klassifikationsdaten in Bezug auf eine eindeutige Identifikatorin der Batterie abzugleichen.

6. Ein System zur Bestimmung einer chemischen Funktionalität und/oder chemischen Zusammensetzung einer Batterie, das System umfasst:
- eine Sammeleinheit zur Erfassung von Batteriedaten, die mindestens eine chemische und/oder physikalische Eigenschaft der chemischen Inhaltsstoffe der Batterie anzeigt;
eine Bereitstellungseinheit zur Bereitstellung von Matching-Daten, indem mindestens ein Matching bestimmt wird
zwischen den gesammelten Batteriedaten und den Daten einer Referenzbatterie, wobei die Matching-Daten bereitgestellt werden, indem die Batterie auf Basis von mindestens einem Parameter der gesammelten Batteriedaten klassifiziert wird, entsprechende Referenzbatterien bezüglich mindestens eines Parameters gefunden und die Daten der gefundenen passenden Referenzbatterien als die passenden Daten identifiziert werden.
wobei die Findung der passenden Referenzbatterien bezüglich mindestens eines Parameters darin besteht, Daten durch einen Datendienst in einer zumindest teilweise dezentralen Rechenumgebung bereitzustellen, wobei der Datendienst auf Referenzbatteriendaten zugrifft.
- wobei Referenzbatteriendaten über eine dezentrale Berechnung erfasst werden Umgebung, in der die Erfassung von Referenzbatteriedaten umfasst: die Bereitstellung einer digitalen Identifikatorin der Batterie, die Bereitstellung der digitalen Identifikatorin für eine dezentrale Rechenschnittstelle, die zur Anforderung von Referenzbatteriedaten konfiguriert ist, sowie die Bereitstellung von Referenzbatteriendaten für die dezentrale Rechenschnittstelle, die zur Abfrage von Referenzbatteriendaten konfiguriert ist; und
- eine Bestimmungs einheit zur Bestimmung von Funktions- und/oder Zusammensetzungsdaten, die die chemische Funktionalität und/oder chemische Zusammensetzung der Batterie anhand der Abgleichsdaten angibt.

7. Das System gemäß Anspruch 6, wobei die bereitstellende Einheit mindestens eine Referenzbatteriedatenbank, ein Modell und/oder ein maschinelles Lernen (ML) umfasst.

8. Das System gemäß Anspruch 6 oder 7, wobei das System außerdem mindestens eine Klassifikationseinheit zur Klassifizierung der Batterie basierend auf Funktionalität und/oder
Zusammensetzungsdaten in einer Vielzahl von Klassen und/oder zur Klassifikation der Batterie auf Grundlage von mindestens einem Parameter der gesammelten Batteriedaten.

9. Verwendung von Batteriedaten und/oder chemischen Funktionsdaten einer Batterie und/oder chemischer Zusammensetzungsdaten einer Batterie in einer Methode gemäß einem der Ansprüche 1 bis 5.

10. Verwendung von Funktionalitäts- und/oder Zusammensetzungsdaten, die durch eine Methode gemäß einer der Ansprüche 1 bis 5 für die Klassifikation und/oder Sortierung von Batterien bestimmt werden.

11. Computerprogrammelement mit Befehlen, die, wenn sie im Computergerät einer Computerumgebung ausgeführt werden, konfiguriert sind die Schritte der Methode gemäß jedem der Ansprüche 1 bis 5 in einem System gemäß einem der Ansprüche 6 bis 8 auszuführen.

12. Nutzung von Funktionalitäts- und/oder Kompositionsdaten und/oder Abgleichsdaten gemäß einer
der Ansprüche 1 bis 5 in einem System gemäß einer der Ansprüche 6 bis 8, um zwischen Recycling oder einer zweiten oder weiteren Nutzung einer Batterie zu entscheiden.

## Revendications

1. Une méthode implémentée par ordinateur pour déterminer la fonctionnalité chimique et/ou la composition chimique d'une batterie, la méthode comprenant:
- la collecte de données sur les batteries indiquant au moins une propriété chimique et/ou physique liée aux ingrédients chimiques de la batterie ;
- fournissant des données de correspondance en déterminant au moins une correspondance entre les données collectées de la batterie et celles d'une batterie de référence,
où les données correspondantes sont fournies en classant la batterie sur la base de au moins un paramètre des données de batterie collectées, trouver les batteries de référence correspondantes par rapport à au moins un paramètre, et identifier les données des batteries de référence correspondantes trouvées comme étant les données correspondantes,
où la recherche des batteries de référence correspondantes par rapport à au moins un paramètre consiste à fournir des données par un service de données dans un au moins partiellement
environnement informatique décentral, dans lequel le service de données accède aux données de batterie de référence,
où les données de batterie de référence sont collectées via un environnement informatique décentralisé, où la collecte des données de batterie de référence inclut : fournir un identifiant numérique de la batterie, fournir l'identifiant numérique à un décentralisateur
interface informatique configurée pour demander des données de batterie de référence, et fournissant des données de batterie de référence à l'interface informatique décentralisée configurée pour demander des données de batterie de référence ; et
- déterminer la fonctionnalité et/ou les données de composition indiquant la fonctionnalité chimique et/ou la composition chimique de la batterie en fonction de la correspondance
Data.

2. La méthode selon la revendication 1, dans laquelle les données de référence de la batterie sont fournies en relation avec la batterie identifiée ou en relation avec l'identifiant identifiant de manière unique la batterie.

3. La méthode, selon les revendications 1 ou 2, consiste à transférer les données de référence de la batterie à inclure un ou plusieurs mécanismes d'authentification et/ou mécanismes d'autorisation associés ou liés à la batterie identifiée ou en relation avec l'identifiant identifiant de manière unique la batterie.

4. La méthode selon l'une des revendications précédentes, où au moins un paramètre est fourni avec l'identifiant à une interface de calcul décentralisée pour demander des données de batterie de référence, où les données de référence de la batterie sont fournies en relation avec au moins un paramètre pour les batteries de référence correspondantes.

5. Selon l'une des revendications précédentes, la méthode comprend en outre une classification de la batterie basée sur les données de fonctionnalité et/ou de composition dans une pluralité de classes, dans laquelle chaque classe spécifie une utilisation de la batterie, où la pluralité des classes inclut de préférence au moins une classe pour une autre
utilisation de la batterie et/ou d'au moins une classe pour le recyclage de la batterie, où la méthode comprend en outre l'étape consistant à fournir les données de fonctionnalité et/ou de composition déterminées, en faisant correspondre les données et/ou les données de classification en relation avec un identifiant unique associé à la batterie.

6. Un système pour déterminer la fonctionnalité chimique et/ou la composition chimique d'une batterie, le système comprenant :
- une unité de collecte pour recueillir des données de batterie indiquant au moins une propriété chimique et/ou physique des ingrédients chimiques de la batterie ;
une unité fournissant des données correspondantes en déterminant au moins une correspondance
entre les données collectées de batterie et celles d'une batterie de référence, où les données correspondantes sont fournies en classant la batterie sur la base d'au moins un paramètre des données collectées, en trouvant les batteries de référence correspondantes par rapport à au moins un paramètre, et en identifiant les données des batteries de référence correspondantes trouvées comme étant les données correspondantes.
où la recherche des batteries de référence correspondantes par rapport à au moins un paramètre consiste à fournir des données par un service de données dans un environnement informatique au moins partiellement décentralisé, où le service de données accède aux données des batteries de référence.
- où les données de batterie de référence sont collectées via un environnement informatique décentralisé la collecte des données de batterie de référence comprend : fournir un identifiant numérique de la batterie, fournir cet identifiant numérique à une interface informatique décentralisée configurée pour demander des données de batterie de référence, et fournir des données de batterie de référence à l'interface de calcul décentralisée configurée pour demander des données de batterie de référence ; et
- une unité de détermination pour déterminer la fonctionnalité et/ou la composition des données indiquant la fonctionnalité chimique et/ou la composition chimique de la batterie à partir des données correspondantes.

7. Le système selon la revendication 6 6, dans lequel l'unité fournissante comprend au moins une base de données de batteries de référence, un modèle et/ou un modèle d'apprentissage automatique, ML.

8. Le système selon la revendication 6 ou 7, dans lequel le système comprend en outre au moins une unité de classification pour classer la batterie en fonction de la fonctionnalité et/ou des données de composition dans une pluralité de classes et/ou pour classer la batterie sur la base d'au moins un paramètre des données de batterie collectées.

9. Utilisation des données de batterie et/ou des données de fonctionnalité chimique d'une batterie et/ou des données de composition chimique d'une batterie selon l'une des revendications 1 à 5.

10. Utilisation des données de fonctionnalité et/ou de composition déterminées par une méthode selon l'une des revendications 1 à 5 pour la classification et/ou le tri des batteries.

11. Élément de programme informatique avec instructions, qui, lorsqu'il est exécuté en informatique les dispositifs d'un environnement informatique, sont configurés pour exécuter les étapes de la méthode selon l'une des revendications 1 à 5 d'un système, selon l'une des revendications 6 à 8.

12. Utilisation des données de fonctionnalité et/ou de composition et/ou de correspondance selon tout l'une des revendications 1 à 5 dans un système selon l'une des revendications 6 à 8 pour décider entre un recyclage ou une seconde ou une utilisation supplémentaire d'une batterie.
